# EUROPÄISCHE PATENTANMELDUNG

(11) **EP 2 407 505 A1**
(43) Veröffentlichungstag der Anmeldung: **18.01.2012**
(21) Anmeldenummer: 10169294.5
(22) Anmeldetag: 12.07.2010
(51) Int. Cl.: C08K 3/34, C08K 9/04

(54) **Polymermaterial mit organisch modifizierten Schichtsilikaten**

(71) Anmelder: Bayer MaterialScience AG, 51368 Leverkusen (DE)
(72) Erfinder: Die Erfindernennung liegt noch nicht vor

(57) **Zusammenfassung**

Die vorliegende Erfindung betrifft ein Polymermaterial, umfassend ein Polymer und ein in dem Polymer dispergiertes organisch modifiziertes Schichtsilikat. In dem Polymermaterial beträgt der Gesamtgehalt an Alkali- und/oder Erdalkalimetallkationen ≤ ppm. Sie betrifft weiterhin dessen Verwendung als Elektretmaterial sowie einen elektromechanischen Wandler, umfassend ein solches Polymermaterial.

## Beschreibung

Die vorliegende Erfindung betrifft ein Polymermaterial, umfassend ein Polymer und ein in dem Polymer dispergiertes organisch modifiziertes Schichtsilikat. Sie betrifft weiterhin dessen Verwendung als Elektretmaterial sowie einen elektromechanischen Wandler, umfassend ein solches Polymermaterial.

Ein Elektret ist ein Dielektrikum, das eine quasi-permanente elektrische Ladung und/oder Polarisierung trägt. Solche Elektrete finden vielfach Verwendung als akustische Membranen, beispielsweise in Mikrofonen, Sensoren und/oder Aktuatoren.

Weiterhin lassen sich Polymerelektrete als selbsthaftende, rückstandslos ablösbare und wiederverwendbare Filme, beispielsweise im Designbereich, in der Plakatwerbung oder bei Informationsschildern verwenden.

Insbesondere werden Polymerelektrete in elektromechanischen, beispielsweise piezoelektrischen, Anordnungen, wie Lautsprechern, Schwingungswandlern, pyroelektrischen Detektoren und Kondensatoren, eingesetzt. Als elektromechanisch beziehungsweise piezoelektrisch bezeichnet man dabei die Fähigkeit, ein elektrisches Potential aufgrund einer ausgeübten mechanischen Belastung auszubilden. Eine elektromechanische, beispielsweise piezoelektrische, Anordnung kann unter anderem durch eine, insbesondere über die Dicke, heterogene Struktur realisiert werden. Beispielsweise sind Mehrschichtanordnungen aus übereinander gestapelten Polymerschäumen und kompakten Polymerfilmen bekannt, in denen die Polymerfilme als Elektret dienen und Ladungen tragen, welche bei mechanischer Beanspruchung der Anordnung zu einer elektrischen Reaktion führen.

In heutigen kommerziell erhältlichen Elektretfilmen, wie sie beispielsweise in Mikrofonen zum Einsatz kommen, wird fast ausschließlich Polytetrafluoroethylen (PTFE) beziehungsweise Polytetrafluoroethylenpropylencopolymer (FEP) als Elektretmaterial verwendet. Der Vorteil dieser fluorierten Polymere ist, dass sie ein gutes Ladungsspeicherverhalten zeigen. Allerdings sind diese Polymere sehr kostspielig und zum anderen, vor allem im Fall von Polytetrafluoroethylen, schwierig zu verarbeiten.

Daraus ergeben sich Bestrebungen, durch Zugabe von Additiven zu einem aus ökonomischer und technischer Sicht besser geeigneten Polymermaterial dessen Elektreteigenschaften zu verbessern. Organisch-chemische Additive zur Verbesserung des Elektretverhaltens von Polycarbonaten werden zum Beispiel in EP 2 159 222 A1 beschrieben. Nachteilig an diesen Additiven ist, dass sie eigens synthetisiert werden müssen.

Schichtsilikate sind eine wichtige Untergruppe der Silikat-Minerale. Sie zeichnen sich durch eine sehr große Variabilität aus und können dadurch für vielfältige Anwendung eingesetzt werden.

In Schichtsilikaten sind SiO₄-Tetraeder zu Schichten mit der Zusammensetzung Si₂O5 vernetzt. Diese Tetraederschichten wechsellagern mit sogenannten Oktaederschichten, in denen ein Kation, vor allem Aluminium und Magnesium, oktaedrisch von Hydroxid beziehungsweise Sauerstoff umgeben ist. Man unterscheidet Zweischicht-Mineralien, wie beispielsweise Kaolinit oder Serpentin, und Dreischicht-Mineralien, vor allem Montmorillonit oder Glimmer. In den Zweischicht-Phyllosilikaten ist jeweils eine Tetraederschicht mit einer Oktaederschicht verbunden, in den Dreischicht-Phyllosilikaten eine Oktaederschicht mit zwei Tetraederschichten.

Aus diesem Grund bauen sich zweidimensionale Schichten auf, die untereinander durch elektrostatische Wechselwirkung zusammengehalten werden. Die eigentlichen Schichten sind selber meist partiell negativ geladen und die Ladungen werden durch Kationen in den Zwischenschichträumen ausgeglichen. Die meisten dieser Verbindungen können daher in Wasser gut gequollen und dispergiert werden. Diesen Prozess nennt man Exfolierung. Durch diesen Prozess werden als "Nanolayer" bezeichnete Partikel erzeugt. Abhängig von der Struktur der Schichtsilikate kann das Aspektverhältnis der Nanolayer stark variieren.

Die Gegenionen in den Zwischenschichten (meist Natriumionen) lassen sich austauschen, so dass die Möglichkeit besteht, die Schichten mit verschiedensten kationischen Verbindungen Oberflächen zu modifizieren. Um diese Schichtsilikate auch mit nichtwässrigen Medien verträglich zu machen, beispielsweise für Polycarbonat, stehen eine große Auswahl von geeigneten Modifikatoren zur Verfügung. Gängige organische Modifikatoren stellen Trimethylalkylammonium-Verbindungen dar, welche an der Oberfläche der Silikatschichten präferenziell adsorbieren und die Schichtsilikate somit hydrophobisieren. Weitere geeignete Modifikatoren sind nichtionische Tenside, anionische Tenside und kationische Tenside sowie Blockcopolymere oder Polyelektrolyte. In Gegenwart niedermolekularer Tenside mit Molekulargewichten von weniger als 1000 g/mol können Cotenside, beispielsweise Alkanole mit C₁- C₁₀-Kohlenstoffketten, erforderlich sein.

Eine organische Modifizierung der Schichtsilikate erfolgt in der Regel, indem das Schichtsilikat in wässriger Lösung vollständig dispergiert wird. Anschließend wird der organische Modifikator zugegeben, der präferenziell auf der Schichtsilikatoberfläche adsorbiert, bis alle Ladungen ausgeglichen sind. Die Suspension kann anschließend gereinigt, getrocknet und als Feststoff weiterverarbeitet werden.

Hinsichtlich modifizierter Tonmaterialien offenbart EP 0 952 187 A1 beispielsweise eine Zusammensetzung aus Ton und einer organisch-chemischen Verbindung, umfassend ein ionenausgetauschtes Reaktionsprodukt, das erhältlich ist aus der Reaktion von einem Smectit-Ton, einer quaternären Ammoniumverbindung und einem nicht-anionischen organischen Material. Weiterhin offenbart diese Patentanmeldung auch ein Nanokomposit, umfassend eine Matrix aus der Gruppe Polymer, Plastik und Harz sowie einer zuvor beschriebenen Zusammensetzung aus Ton und einer organisch-chemischen Verbindung. Der hybride Organo-Ton besteht aus einem organisch-chemischen/Phyllosilikat-Ton-Intercalat, das mit quaternären Ammoniumverbindungen ionenausgetauscht wurde. Da dieser hybride Organo-Ton hydrophob ist, könne er mit Wasser gewaschen werden, um Reaktionssalze und überschüssige wasserlösliche oder wasserdispergierbare Polymere zu entfernen. Ein sauberes Produkt könne durch kostengünstige Maßnahmen wie Filtration erhalten werden. Auf diese Weise würden energieintensive Wege zur Wasserentfernung vermieden. Ein Anwendungsgebiet für einen solchen Ton sei als rheologisches Additiv.

Es findet sich jedoch keine Erwähnung der Elektreteigenschaften des Nanokomposits. Diese Patentanmeldung beschäftigt sich weiterhin nicht mit der Frage, ob das Polymermaterial durch kationische Verunreinigungen eine geringere Stabilität aufweist.

Die vorliegende Erfindung hat sich daher die Aufgabe gestellt, alternative Polymermaterialien bereitzustellen, die sich als Elektrete eignen und leicht zu verarbeiten sind.

Erfindungsgemäß gelöst wird die Aufgabe durch ein Polymermaterial, umfassend ein Polymer und ein in dem Polymer dispergiertes organisch modifiziertes Schichtsilikat, wobei das Polymermaterial sich dadurch auszeichnet, dass in dem Polymermaterial der Gesamtgehalt an Alkali- und/oder Erdalkalimetallkationen ≤ 1 ppm beträgt.

Die Bestimmung des Gehalts der genannten Kationen kann vorzugsweise mittels Atomabsorptionsspektroskopie (AAS) erfolgen. Solch niedrige Gehalte insbesondere an Natriumionen führen zu einem deutlich verringerten oder verhinderten Kettenabbau von empfindlichen Polymeren, in denen die Monomere über hydrolysierbare Bindungen miteinander verknüpft sind. Hierbei kommt insbesondere Polycarbonat in Betracht.

Auf diese Weise können beispielsweise füllstoffhaltige Polymerelektretfolien im Extrusions- oder Kalandrierungsverfahren herstellt werden, ohne dass auf einen möglichen Polymerkettenabbau bei den üblichen Verarbeitungstemperaturen Rücksicht genommen werden müsste.

Das erfindungsgemäße Polymermaterial zeigt gegenüber einem Polymer ohne Zugabe der organisch modifizierten Schichtsilikate nach einer Aufladung einen geringeren Abfall des Oberflächenpotentials. Nach einer Corona-Aufladung bei 500 V Spannung kann beispielsweise die Abnahme dieses Potentials gegenüber dem ursprünglichen Potential Ψ/Ψ₀ nach einer Temperung bei 120 °C für 24 Stunden in einem Bereich von ≥ 30% bis ≤ 50% liegen.

Das erfindungsgemäße Polymermaterial lässt sich durch ein Verfahren herstellen, welches den Schritt des Kontaktierens einer Dispersion des Schichtsilikats mit einer organischen Verbindung umfasst, wobei die Gesamtladung der organischen Verbindung vorzugsweise mindestens einfach positiv ist und wobei weiterhin das Kontaktieren in Gegenwart eines Ionenaustauscherharzes durchgeführt wird.

Auf diese Weise lässt sich der Gehalt an freien Kationen, welche durch die vorzugsweise positiv geladene organische Verbindung aus dem Schichtsilikat verdrängt wurden, deutlich verringern. Dieses spart aufwendigere Wasch- und Reinigungsschritte.

Das Polymer dient als Matrix, innerhalb derer das Schichtsilikat dispergiert ist. Vorzugsweise handelt es sich um eine homogene Dispersion. Geeignete Polymere sind beispielsweise Polyolefine, Polyurethane, Polyester, Polyether und/oder Polycarbonate.

Der Begriff "organisch modifiziertes Schichtsilikat" bedeutet im Zusammenhang der vorliegenden Erfindung ein Schichtsilikat, an welches organische Verbindungen gebunden sind. Vorzugsweise sind die organischen Verbindungen mittels ionischer Wechselwirkungen an das Schichtsilikat gebunden.

Geeignete Schichtsilikate sind insbesondere die zuvor erwähnten Zweischicht- und/oder Dreischicht-Phyllosilikate. Es ist möglich, dass sie bereits vor der in der vorliegenden Erfindung beschriebenen Modifizierung eine vorhergehende Modifizierung erhalten haben, um sie beispielsweise quellfähiger zu machen. Allerdings ist es unter anderem aus Kostengründen bevorzugt, dass unmodifizierte Schichtsilikate eingesetzt werden.

Bei der Modifikation der Schichtsilikate werden sie als Dispersion eingesetzt. Das Dispersionsmittel sollte hierbei in der Lage sein, den positiv geladenen organischen Modifikator und die aus dem Schichtsilikat verdrängten Kationen zu lösen.

Vorzugsweise findet die Dispersion des Schichtsilikats in einem Dispersionsmittel statt, welches Wasser und/oder eine ionische Flüssigkeit umfasst. Insbesondere handelt es sich bei den ionischen Flüssigkeiten um solche, die bei Raumtemperatur flüssig sind und bei denen das Kation organisch ist. Dieses kann dann auch zur Modifikation der Schichtsilikate eingesetzt werden. Die Verwendung von Wasser ist ebenfalls günstig, da Wasser durch destillative und/oder Membrantrennverfahren gereinigt werden und danach dem Verfahren wieder zugeführt werden kann.

Das Schichtsilikat wird vorzugsweise mit einer organischen Verbindung kontaktiert, deren Gesamtladung mindestens einfach positiv ist. Hierunter ist die Gesamtladung jeweils eines Moleküls der organischen Verbindung zu verstehen.

Geeignete organische Verbindungen sind unter anderem solche organischen Moleküle mit mindestens einer einfachen positiven Ladung, in denen die positive Ladung durch mindestens eine quaternäre Ammoniumgruppe hervorgerufen wird.

Geeignete organische Verbindungen sind jedoch weiterhin unter anderem Polymere, besonders bevorzugt Blockcopolymere, die entsprechend Foerster und Antonietti (Foerster, S. & Antonietti, M., Advanced Materials, 10, no. 3, (1998) 195) einen Solvatblock für die Wechselwirkung mit dem Lösungsmittel sowie einen funktionellen Block für die Wechselwirkung mit der Partikeloberfläche tragen. Derartige Wechselwirkungen können insbesondere vom Typ Liganden-, Säure-Base-, elektrostatische und/oder komplexe, niederenergetische Wechselwirkungen sein.

Wie bereits ausgeführt, soll vorzugsweise die Gesamtladung des Moleküls der organischen Verbindung mindestens einfach positiv sein. Dieses lässt sich insbesondere über Protonierung oder Alkylierung geeigneter Gruppen im funktionellen Block des Moleküls erreichen.

Die organischen Verbindungen weisen bevorzugt Molmassen von ≥ 400 g/mol bis ≤ 20000 g/mol und mehr bevorzugt ≥ 1000 g/mol bis ≤ 10000 g/mol auf (Molmassen nach DIN 53240 OH-Zahlbestimmung).

Im Rahmen der Modifikation der Silikate wird weiterhin das Kontaktieren in Gegenwart eines Ionenaustauscherharzes durchgeführt. Durch dieses Ionenaustauscherharz werden die aus dem Schichtsilikat verdrängten Kationen gebunden und gegen H⁺-Ionen ausgetauscht. Anschließend kann das Harz abfiltriert werden. Auf diese Weise lässt sich eine sehr einfache Reinigung der Dispersion durchführen. Vorzugsweise umfasst das Ionenaustauscherharz basisches und saures Ionenaustauscherharz. Dann können auch aus einer Protonierung von funktionellen Gruppen der organischen Verbindung herrührende Anionen gebunden und abgetrennt werden. Als Beispiel seien Chloridionen genannt, wenn eine aminische organische Verbindung mit Salzsäure protoniert wird.

Die Erfindung wird nachfolgend im Zusammenhang mit bevorzugten Ausführungsformen beschrieben, die beliebig miteinander kombiniert werden können, solange sich nicht eindeutig das Gegenteil ergibt. Weiterhin sei angemerkt, dass im Rahmen der vorliegenden Erfindung die Begriffe "ein", "eine", etc. nicht als Zahlwörter zu verstehen sind, solange sich aus dem Zusammenhang nicht eindeutig das Gegenteil ergibt.

In einer Ausführungsform des erfindungsgemäßen Polymermaterials umfasst das organisch modifizierte Schichtsilikat ein Schichtsilikat, an das Verbindungen gebunden sind, die ausgewählt sind aus der Gruppe umfassend:
Alkylammoniumverbindungen der allgemeinen Formel (NR¹R²,R³,R⁴)⁺, wobei R¹, R², R³ und R⁴ unabhängig voneinander jeweils bedeuten können:
   C₁-C₁₈-Alkyl, C₆-C₁₂-Aryl, durch ein oder mehrere Sauerstoffatome unterbrochenes C₂-C₁₈-Alkyl, C₅-C₁₂-Cycloalkyl, C₁-C₁₈-Alkylcarbonyl, C₁-C₁₈-Alkyloxycarbonyl, C₅-C₁₂-Cycloalkylcarbonyl, C₆ - C₁₂-Arylcarbonyl,
   wobei die genannten Reste jeweils durch funktionelle Gruppen, Aryl, Alkyl, Aryloxy, Alkyloxy, Halogen, Heteroatome und/oder Heterocyclen substituiert sein können und/oder 1, 2, 3 oder 4 Doppelbindungen tragen können und
   wobei R¹, R², R³ und R⁴ Wasserstoff bedeuten können, solange mindestens einer dieser Reste die zuvor beschriebene Bedeutung innehat;
Blockcopolymere, die einen Solvatblock und einen funktionellen Block umfassen,
   wobei der Solvatblock ausgewählt ist aus der Gruppe umfassend Poly(styrolsulfonsäure), Poly(N-Alkylvinylpyridinium Halogenid), Poly(methacrylsäure), Poly(methacrylate), Poly(N-Vinylpyrrolidon), Poly(Hydroxyethylmethacrylat), Poly(vinylether), Poly(ethylenoxid), Poly(propylenoxid), Poly(vinyl methyl ether), Poly(vinyl butyl ether), Polystyrol, Poly(ethylenpropylen), Poly(ethylethylen), Poly(isobutylen), Poly(dimethylsiloxan) und/oder partiell fluorierte Blöcke (PF); und
   wobei der funktionelle Block ausgewählt ist aus der Gruppe umfassend sind Poly(N-Alkylvinylpyridinium Halogenid), Poly(dimethylsiloxan), partiell fluorierte Blöcke (PF), Poly(ethylenoxid), Ligandenhaltige Blöcke, Mercaptogruppen enthaltende Blöcke, Poly(methacrylsäure), Poly(styrolsulfonsäure), Poly(cyclopentadienylmethylnorbornen), Poly(aminosäure)-blöcke, PEO-PPO-PEO- oder PPO-PEO-PPO-Blockcopolymere, Copolymere mit Poly(ethylenoxid)-Poly(methylmethacrylat)- oder Poly(ethylenoxid)-Poly(n-butylacrylat)-Blöcken, Amin-Derivate und/oder Polyoxyalkylen-Amine.

Der Ausdruck "Alkyl" bedeutet im Sinne dieser Erfindung acyclische gesättigte oder ungesättigte aliphatische Kohlenwasserstoffreste, die jeweils verzweigt oder unverzweigt sowie unsubstituiert oder ein- oder mehrfach substituiert sein können. Bevorzugt ist Alkyl aus der Gruppe ausgewählt, die Methyl, Ethyl, n-Propyl, 2-Propyl, n-Butyl, iso-Butyl, sec.-Butyl, tert.-Butyl, n-Pentyl, isoPentyl, neo-Pentyl, n-Hexyl, n-Heptyl, n-Octyl, n-Nonyl, n-Decyl und höhere Homologe bis hin zu n-Octadecyl umfasst.

Der Begriff "Aryl" bedeutet im Sinne dieser Erfindung aromatische Kohlenwasserstoffe mit bis zu 12 Ringgliedern, insbesondere Phenyle und Naphthyle. Jeder Aryl-Rest kann unsubstituiert oder einfach oder mehrfach substituiert vorliegen, wobei die Aryl-Substituenten gleich oder verschieden und in jeder beliebigen und möglichen Position des Aryls sein können. Bevorzugt ist Aryl aus der Gruppe ausgewählt, die Phenyl, 1-Naphthyl und 2-Naphthyl enthält, welche jeweils unsubstituiert oder ein- oder mehrfach substituiert sein können. Ein besonders bevorzugtes Aryl ist Phenyl, unsubstituiert oder einfach oder mehrfach substituiert.

"Halogene" sind insbesondere F, Cl, Br und I. "Heteroatome" sind insbesondere N, P, O und S.

Der Begriff "Heterocyclen" umfasst zum Einen aliphatische gesättigte oder ungesättigte (aber nicht aromatische) Cycloalkyle mit insbesondere drei bis zehn Ringgliedern, in denen mindestens ein, gegebenenfalls auch zwei oder drei Kohlenstoffatome durch ein Heteroatom oder eine Heteroatomgruppe jeweils unabhängig voneinander ausgewählt aus der Gruppe bestehend aus O, S, S(=O)2, N, NH und N(C₁-₈-Alkyl), vorzugsweise N(CH₃) ersetzt sind, wobei die Ringglieder unsubstituiert oder ein- oder mehrfach substituiert sein können.

Weiterhin eingeschlossen in den Begriff "Heterocyclen" sind Heteroaromaten. Dieses steht für einen 5- oder 6-gliedrigen cyclischen aromatischen Rest, der mindestens 1, gegebenenfalls auch 2, 3, 4 oder 5 Heteroatome, enthält, wobei die Heteroatome jeweils unabhängig voneinander ausgewählt sind aus der Gruppe S, N und O und der Heteroaryl-Rest unsubstituiert oder ein- oder mehrfach substituiert sein kann; im Falle der Substitution am Heteroaryl können die Substituenten gleich oder verschieden sein und in jeder beliebigen und möglichen Position des Heteroaryls sein.

Vorteilhafterweise sind die Alkylammoniumverbindungen der allgemeinen Formel (NR¹R²,R³,R⁴)⁺ protonierte Ammoniumalkoxylate der allgemeinen Formeln (I) und/oder (II): 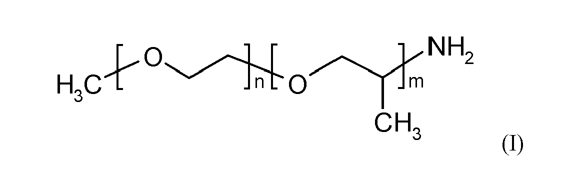 mit einem durch die Koeffizienten m und n angegebenen Verhältnis von Propylenoxid- zu Ethylenoxideinheiten von ≥ 1:20 bis ≤ 20:1;

(R)((CH₂CH₂O)ₓ)H)((CH₂CH₂O)_{y})H)N (II)

wobei R einen C₁₀-C₂₀-Alkylrest darstellt und die Summe x + y in einem Bereich von ≥ 2 bis ≤30 liegt.

Das durch die Koeffizienten m und n angegebenen Verhältnis von Propylenoxid- zu Ethylenoxideinheiten in der allgemeinen Formel (I) kann vorzugsweise > 4:1 bis < 6:1 betragen. Die zahlenmittleren Molekülmasse liegt vorzugsweise in einem Bereich von ≥ 500 g/mol bis ≤5000 g/mol und mehr bevorzugt von ≥1800 g/mol bis ≤ 2200 g/mol. Verbindungen dieses Typs sind unter der Handelsbezeichnung Jeffamine® kommerziell erhältlich.

In der allgemeinen Formel (II) kann der C₁₀-C₂₀-Alkylrest R beispielsweise Cocyl, Oleyl oder Stearyl darstellen. Vorzugsweise liegt die Summe x + y in einem Bereich vorzugsweise ≥10 bis < 25. Verbindungen dieses Typs sind unter der Handelsbezeichnung Genamine® kommerziell erhältlich.

In einer weiteren Ausführungsform des erfindungsgemäßen Polymermaterials beträgt in dem Polymermaterial der Gesamtgehalt an Alkali- und/oder Erdalkalimetallkationen ≥ 0,1 ppm bis ≤ 0,5 ppm. Vorzugsweise beträgt der Gesamtgehalt ≥ 0,2 ppm bis ≤ 0,4 ppm.

In einer weiteren Ausführungsform des erfindungsgemäßen Polymermaterials umfasst das Polymer Polycarbonat. Dieser Polymertyp ist besonders empfindlich gegenüber Verunreinigungen. Polycarbonat reagiert auf Verunreinigungen von Zuschlagsstoffen in Form von Ionen durch einen Abbau der Polymerkettenlänge, was sich gemeinhin auch durch eine Eintrübung und/oder gelblich bräunliche Einfärbung des Polymers bemerkbar macht.

In einer weiteren Ausführungsform des erfindungsgemäßen Polymermaterials ist das Schichtsilikat ausgewählt aus der Gruppe umfassend Serpentin, Kaolin, Talk, Pyrophyllit, Smectit, Vermiculit, Illit, Glimmer und/oder Sprödglimmer. Bevorzugt sind hierbei Smectite. Zu den Smectiten zählen auch die Montmorillonite, welche im Rahmen der vorliegenden Erfindung besonders bevorzugte Schichtsilikate sind.

In einer weiteren Ausführungsform des erfindungsgemäßen Polymermaterials beträgt der Anteil des modifizierten Schichtsilikats im Polymer ≥ 0,005 Gewichts-% bis ≤ 5 Gewichts-%. Vorzugsweise beträgt der Anteil ≥0,007 Gewichts-% bis ≤1 Gewichts-% oder≥0,01 Gewichts-% bis ≤ 0,1 Gewichts-%. Der Gewichtsanteil des Polymers berechnet sich einschließlich etwaiger zugesetzter Additive, Füllstoffe und dergleichen.

Ein weiterer Gegenstand der vorliegenden Erfindung ist die Verwendung eines erfindungsgemäßen Polymermaterials als Elektretmaterial. Dieses Elektretmaterial kann in einer elektromechanischen, beispielsweise piezoelektrischen, Anordnung eingesetzt werden. Vorzugsweise wird das Elektretmaterial in einem Sensor, Aktuator und/oder Generator eingesetzt. Insbesondere kann der Einsatz in einem Mikrofon oder Lautsprecher, beispielsweise als akustische Membran, in einem Schwingungswandler, in einem pyroelektrischen Detektor oder in einem Kondensator erfolgen.

Solch ein Elektretelement kann dabei beispielsweise durch Pressen, insbesondere Schmelzpressen, Rakeln, insbesondere Lösungsrakeln, Streichen, Schleudern, insbesondere Lackschleudern, Sprühen, Extrusion, insbesondere Folienextrusion, Blasformen, insbesondere Folienblasen, und/oder Kalandern hergestellt werden.

Das Aufladen des Elektretelements kann durch Triboaufladung, Elektronenstrahlbeschuss, Abkühlen der Polymerschmelze im elektrischen Feld, Anlegen einer elektrischen Spannung oder Coronaentladung erfolgen.

Ein elektromechanischer Wandler, umfassend ein erfindungsgemäßes Polymermaterial ist ebenfalls Gegenstand der vorliegenden Erfindung. Diese elektromechanischen Wandler sind hierbei vorzugsweise Sensoren, Aktuatoren und/oder Generatoren, insbesondere in einem Mikrofon oder Lautsprecher, beispielsweise als akustische Membran, in einem Schwingungswandler oder in einem pyroelektrischen Detektor.

Die Erfindung wird anhand der nachfolgenden Beispiele und der Figur weiter erläutert, ohne jedoch darauf beschränkt zu sein.

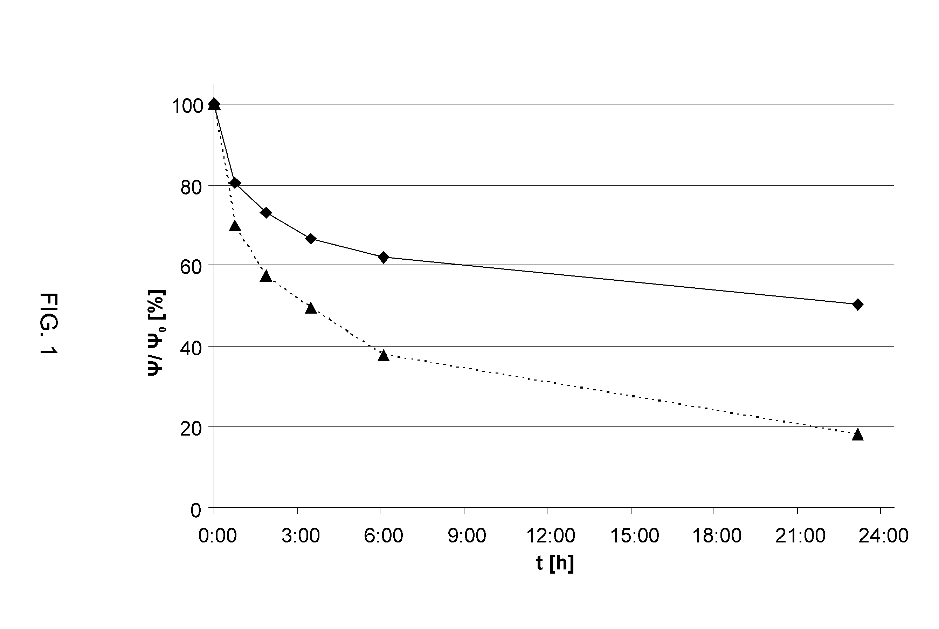

FIG. 1 zeigt den zeitlichen Verlauf der Abnahme des Oberflächenpotentials für ein modifiziertes und ein unmodifiziertes Polycarbonatmaterial.

### Beispiel 1: Herstellung eines organisch modifizierten Schichtsilikats mit Jeffamine® M2005

Jeffamine® M2005 (Firma Huntsman) ist ein Polyetheramin der Formel: 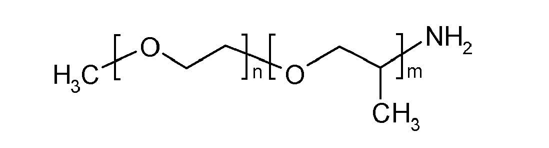 mit einem molaren Verhältnis von Propylenoxid- zu Ethylenoxideinheiten von 29:6 und einer Molekularmasse M_{w} von 2000 g/mol.

3 kg einer 5%igen Dispersion von natürlichem, unmodifiziertem Schichtsilikat (Polymer Grade Montmorillonite PGV, Artikelnummer 105934, Firma Nordmann, Rassmann GmbH) in destilliertem Wasser wurden über Nacht im Schüttelbad geschüttelt.

In einem Dreihalskolben wurden 340,2 g Jeffamine® M2005 in 700 mL destilliertem Wasser, welches unter Rühren mit konzentrierter Salzsäure auf einen pH-Wert von 2 eingestellt wurde, vorgelegt und mittels eines Wasserbades auf 80 °C erhitzt.

Die Schichtsilikat-Suspension wurde zugetropft. Hierbei wurde der pH-Wert kontrolliert und bei Bedarf mit konzentrierter Salzsäure nachgestellt, so dass der pH-Wert bei etwa 3 lag. Die Mischung wurde bei 80 °C für drei Stunden weiter gerührt. Anschließend wurde die Mischung unter Rühren langsam bis zur Raumtemperatur abgekühlt.

Die somit erhaltene Dispersion wurde abgenutscht, in eine Feststofffraktion und eine flüssige Fraktion getrennt und die feuchte Feststofffraktion wurde wieder in frisches destilliertes Wasser aufgenommen. Die Leitfähigkeit der Suspension fiel dadurch von ca. 4 mS/cm auf ca. 1 mS/cm.

Zu der erneut dispergierten Feststofffraktion wurde unter Rühren ein Ionentauscherharz (Lewatit® UltraPure 1294 MD, Firma Lanxess; 1:1 Mischung eines basischen Anionenaustauscherharzes und eines sauren Kationenaustauscherharzes) hinzugegeben (dabei wurde nur Harz verwendet, der auf einem 500 µm Sieb verbleiben kann), während man hierbei die Leitfähigkeit der Dispersion kontrollierte.

Die Zugabe wurde gestoppt, als die die Leitfähigkeit auf einen Wert von < 20 µS/cm gesunken war. Schließlich wurde der Ionentauscher mit einem 400 µm Sieb abgetrennt.

Das modifizierte Schichtsilikat wurde durch Filtration mittels Nutsche von der Dispersion abgetrennt. Das feuchte Schichtsilikat wird mit etwas Wasser redispergiert, in flüssigem Stickstoff vertropft und anschließend gefriergetrocknet.

### Beispiel 2: Herstellung eines organisch modifizierten Schichtsilikats mit Genamine® S 080

Genamine® S 080 (Firma Clariant) ist ein Stearylaminoethoxylat der Formel (R)((CH₂CH₂O)ₓ)H)((CH₂CH₂O)_{y})H)N mit x + y = 8 und R = Stearyl.

3 kg einer 5%igen Dispersion von natürlichem, unmodifiziertem Schichtsilikat (Polymer Grade Montmorillonite PGV, Artikelnummer 105934, Firma Nordmann, Rassmann GmbH) in destilliertem Wasser wurden über Nacht im Schüttelbad geschüttelt.

In einem Dreihalskolben wurden 107,5 g Genamine® S080 in 700 mL destilliertem Wasser, welches unter Rühren mit konzentrierter Salzsäure auf einen pH-Wert von 2 eingestellt wurde, vorgelegt und mittels eines Wasserbades auf 80 °C erhitzt.

Die Schichtsilikat-Suspension wurde zugetropft. Hierbei wurde der pH-Wert kontrolliert und bei Bedarf mit konz. Salzsäure nachgestellt, so dass der pH-Wert bei etwa 3 lag. Die Mischung wurde bei 80°C für drei Stunden weiter gerührt. Anschließend wurde die Mischung unter Rühren langsam bis zur Raumtemperatur abgekühlt.

Die somit erhaltene Dispersion wurde abgenutscht, in eine Feststofffraktion und eine flüssige Fraktion getrennt und die feuchte Feststofffraktion wurde wieder in frischem destilliertem Wasser aufgenommen. Die Leitfähigkeit der Suspension fiel dadurch von ca. 4 mS/cm auf ca. 1 mS/cm.

Zu der erneut dispergierten Feststofffraktion wurde unter Rühren ein Ionentauscherharz (Lewatit® UltraPure 1294 MD, Firma Lanxess; 1:1 1 Mischung eines basischen Anionenaustauscherharzes und eines sauren Kationenaustauscherharzes) hinzugegeben (dabei wird nur Harz verwendet, der auf einem 500 µm Sieb verbleiben kann), während man hierbei die Leitfähigkeit der Dispersion kontrollierte.

Die Zugabe wurde gestoppt, als die die Leitfähigkeit auf einen Wert von < 20 µS/cm gesunken war. Schließlich wurde der Ionentauscher mit einem 400 µm Sieb abgetrennt.

Das modifizierte Schichtsilikat wurde durch Filtration mittels Nutsche von der Dispersion abgetrennt. Das feuchte Schichtsilikat wird mit etwas Wasser redispergiert, in flüssigem Stickstoff vertropft und anschließend gefriergetrocknet.

### Beispiel 3: Trocknen und Einbringen der modifizierten Schichtsilikate in ein Polymer

Das modifizierte Schichtsilikat aus Beispiel 2 wurde getrocknet und anschließend zusammen mit einem Polycarbonat (Makrolon® 1140, Firma Bayer Material Science AG) extrudiert, so dass die Konzentration an modifiziertem Schichtsilikat 1 Gewichts-% im Polymer betrug.

Anschließend wurde das erhaltene Material mittels Viskositätsmessungen auf den Molmassenabbau hin überprüft, der ein geeigneter Indikator für die Verträglichkeit und Reinheit des Schichtsilikatmaterials mit dem Polymer ist. Würde das Schichtsilikatmaterial einen hohen Anteil an Verunreinigungen insbesondere in Form von Natriumionen enthalten, so würde die Molmasse des Polymers (hier Polycarbonat, das diesbezüglich besonders empfindlich reagiert) nach dem Einbringen des Schichtsilikatmaterials signifikant gegenüber seinem Ursprungswert sinken.

Eine Messmethode zur Bestimmung der Veränderung der Molmasse von Polycarbonat ist die Messung der dynamischen Viskosität vor und nach Behandlung des Polycarbonats. Bei diesem Verfahren werden die Durchlaufzeiten eines gelösten Polymers durch ein Ubbelohde-Viskosimeter gemessen, um anschließend den Viskositätsunterschied zwischen Polymerlösung und seinem Lösungsmittel zu bestimmen. Daraus lässt sich unter Berücksichtigung der Massekonzentration der Polymerlösung die Viskositätszahl ermitteln. Die Viskositätszahl lässt sich mit der Molmasse eines Polymers korrelieren.

Es ergab sich eine relative Viskosität von 1,312 im Vergleich zu 1,320 für das reine Polycarbonat.

Demnach hat das Einbringen des so erzeugten, reinen Schichtsilikatmaterials die Molmasse des Polycarbonats nicht signifikant negativ beeinflusst.

### Beispiel 4: Erhöhung der Ladungsspeicherfähigkeit von Polycarbonat durch modifizierte Schichtsilikat-Additive

Das modifizierte Schichtsilikat aus Beispiel 2 wurde getrocknet und anschließend zusammen mit einem Polycarbonat (Makrolon® 3108, Firma Bayer Material Science AG) in einem Kneter compoundiert, so dass die Konzentration an modifiziertem Schichtsilikat 0,01 Gewichts-% im Polymer betrug. Das erhaltene Granulat wurde auf einem Einschneckenextruder zu Folien von 100 µm Dicke extrudiert.

Die Folien wurden mittels Coronaentladung bei einer Spannung von 500 V aufgeladen. Anschließend wurde der isotherme Oberflächenladungsabfall während einer Dauer von 24 Stunden bei einer Temperatur von 120 °C bestimmt. Die Ergebnisse sind in FIG. 1 dargestellt. Hierbei zeigt die obere Kurve (durchgezogene Linie) den zeitlichen Abfall des Oberflächenpotentials Ψ ausgehend von einem ursprünglichen Oberflächenpotential Ψ₀ für das in diesem Beispiel modifizierte Polycarbonat. Die untere Kurve (gestrichelt Linie) zeigt zum Vergleich den Verlauf für das unmodifizierte Polycarbonat.

Es zeigte sich, dass durch die Zugabe der modifizierten Schichtsilikate das Ladungsspeichervermögen des Polycarbonats verbessert werden konnte. Während im unmodifizierten Polycarbonat nach 24 Stunden bei 120 °C nur 18% des ursprünglichen Oberflächepotentials übrig blieben, betrug dieser Wert für das additivierte Polymer 50%.

### Beispiel 5: Erhöhung der Ladungsspeicherfähigkeit von Polycarbonat durch modifizierte Schichtsilikat-Additive

Es wurde analog zum Beispiel 4 verfahren, mit dem Unterschied, dass nunmehr das modifizierte Schichtsilikat aus Beispiel 1 verwendet wurde. Es wurden in zwei Experimenten Gehalte des modifizierten Schichtsilikats im Polycarbonat von 0,03 Gewichts-% und 0,06 Gewichts-% eingestellt. Nach einer Temperung bei 120 °C über 24 Stunden beobachtete man in beiden Fällen ein Oberflächenpotential von 36% des Ausgangswertes.

## Patentansprüche

1. Polymermaterial, umfassend ein Polymer und ein in dem Polymer dispergiertes organisch modifiziertes Schichtsilikat, **dadurch gekennzeichnet, dass** in dem Polymermaterial der Gesamtgehalt an Alkali- und/oder Erdalkalimetallkationen < 1 ppm beträgt.

2. Polymermaterial gemäß Anspruch 1, wobei das organisch modifizierte Schichtsilikat ein Schichtsilikat umfasst, an das Verbindungen gebunden sind, die ausgewählt sind aus der Gruppe umfassend:
Alkylammoniumverbindungen der allgemeinen Formel (NR¹R²,R³,R⁴)⁺, wobei R¹, R², R³ und
R⁴ unabhängig voneinander jeweils bedeuten können:
C₁-C₁₈-Alkyl, C₆-C₁₂-Aryl, durch ein oder mehrere Sauerstoffatome unterbrochenes C₂-C₁₈-Alkyl, C₅-C₁₂-Cycloalkyl, C₁-C₁₈-Alkylcarbonyl, C₁-C₁₈-Alkyloxycarbonyl, C₅-C₁₂-Cycloalkylcarbonyl, C₆ - C₁₂-Arylcarbonyl,
wobei die genannten Reste jeweils durch funktionelle Gruppen, Aryl, Alkyl, Aryloxy, Alkyloxy, Halogen, Heteroatome und/oder Heterocyclen substituiert sein können und/oder 1, 2, 3 oder 4 Doppelbindungen tragen können und
wobei R¹, R², R³ und R⁴ Wasserstoff bedeuten können, solange mindestens einer dieser Reste die zuvor beschriebene Bedeutung innehat;
Blockcopolymere, die einen Solvatblock und einen funktionellen Block umfassen,
wobei der Solvatblock ausgewählt ist aus der Gruppe umfassend Poly(styrolsulfonsäure), Poly(N-Alkylvinylpyridinium Halogenid), Poly(methacrylsäure), Poly(methacrylate), Poly(N-Vinylpyrrolidon), Poly(Hydroxyethylmethacrylat), Poly(vinylether), Poly(ethylenoxid), Poly(propylenoxid), Poly(vinyl methyl ether), Poly(vinyl butyl ether), Polystyrol, Poly(ethylenpropylen), Poly(ethylethylen), Poly(isobutylen), Poly(dimethylsiloxan) und/oder partiell fluorierte Blöcke (PF); und
wobei der funktionelle Block ausgewählt ist aus der Gruppe umfassend sind Poly(N-Alkylvinylpyridinium Halogenid), Poly(dimethylsiloxan), partiell fluorierte Blöcke (PF), Poly(ethylenoxid), Ligandenhaltige Blöcke, Mercaptogruppen enthaltende Blöcke, Poly(methacrylsäure), Poly(styrolsulfonsäure), Poly(cyclopentadienylmethylnorbornen), Poly(aminosäure)-blöcke, PEO-PPO-PEO- oder PPO-PEO-PPO-Blockcopolymere, Copolymere mit Poly(ethylenoxid)-Poly(methylmethacrylat)- oder Poly(ethylenoxid)-Poly(n-butylacrylat)-Blöcken, Amin-Derivate und/oder Polyoxyalkylen-Amine.

3. Polymermaterial gemäß Anspruch 2, wobei die Alkylammoniumverbindungen der allgemeinen Formel (NR¹R²,R³,R⁴)⁺ protonierte Ammoniumalkoxylate der allgemeinen Formeln (I) und/oder (II) sind: 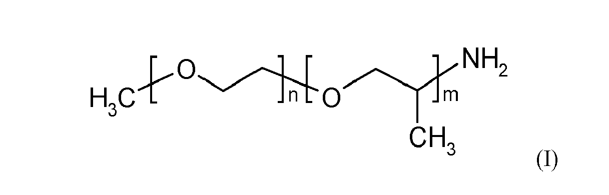 mit einem durch die Koeffizienten m und n angegebenen Verhältnis von Propylenoxid- zu Ethylenoxideinheiten von ≥ 1:20 bis ≤ 20:1;
(R)((CH₂CH₂O)ₓ)H)((CH₂CH₂O)_{y})H)N (II)
wobei R einen C₁₀-C₂₀-Alkylrest darstellt und die Summe x + y in einem Bereich von ≥ 2 bis < 30 liegt.

4. Polymermaterial gemäß Anspruch 1, wobei in dem Polymermaterial der Gesamtgehalt an Alkali- und/oder Erdalkalimetallkationen ≥0,1 ppm bis ≤0,5 ppm beträgt.

5. Polymermaterial gemäß Anspruch 1, wobei das Polymer Polycarbonat umfasst.

6. Polymermaterial gemäß Anspruch 1, wobei das Schichtsilikat ausgewählt ist aus der Gruppe umfassend Serpentin, Kaolin, Talk, Pyrophyllit, Smectit, Vermiculit, Illit, Glimmer und/oder Sprödglimmer.

7. Polymermaterial gemäß Anspruch 1, wobei das organisch modifizierte Schichtsilikat ein mit Ammoniumalkoxylaten modifiziertes Schichtsilikat umfasst.

8. Polymermaterial gemäß Anspruch 1, wobei der Anteil des modifizierten Schichtsilikats im Polymer ≥0,005 Gewichts-% bis ≤5 Gewichts-% beträgt.

9. Verwendung eines Polymermaterials gemäß einem der Ansprüche 1 bis 8 als Elektretmaterial.

10. Verwendung gemäß Anspruch 9, wobei das Elektretmaterial in einem Sensor, Aktuator und/oder Generator eingesetzt wird.

11. Elektromechanischer Wandler, umfassend ein Polymermaterial gemäß einem der Ansprüche 1 bis 8.

12. Elektromechanischer Wandler gemäß Anspruch 11, wobei der Wandler ein Sensor, Aktuator und/oder Generator ist.
